# EUROPÄISCHE PATENTSCHRIFT

(11) **EP 1 294 019 B1**
(45) Veröffentlichungstag und Bekanntmachung des Hinweises auf die Patenterteilung: **27.04.2005**
(21) Anmeldenummer: 02018589.8
(22) Anmeldetag: 19.08.2002
(51) Int. Cl.: H01L 21/768, H01L 21/3105

(54) **Verfahren zum Herstellen einer Halbleiterstruktur unter Verwendung einer Schutzschicht**
Process of manufacturing a semiconductor structure using a protective layer
Procédé de fabrication d'une structure semi-conductrice utilisant une couche de protection

(30) Priorität: 17.09.2001 DE 10145724
(43) Veröffentlichungstag der Anmeldung: 19.03.2003
(73) Patentinhaber: Infineon Technologies AG, 81669 München (DE)
(72) Erfinder: Holz, Jürgen, Dr., 80804 München (DE)
(74) Vertreter: Kindermann, Peter

(56) Entgegenhaltungen:
- EP-A- 0 312 154
- EP-A- 0 316 550
- US-A- 4 654 269
- US-A- 6 017 614
- US-B1- 6 177 338
- PATENT ABSTRACTS OF JAPAN vol. 015, no. 492 (P-1287), 12. Dezember 1991 (1991-12-12) & JP 03 213870 A (SEMICONDUCTOR ENERGY LAB CO LTD), 19. September 1991 (1991-09-19)

## Beschreibung

Die Erfindung betrifft ein Verfahren, bei dem auf einem Substrat eine Halbleiterstruktur erzeugt wird. Auf die Halbleiterstruktur wird eine Schutzschicht aufgebracht, um die Halbleiterstruktur vor Beeinträchtigungen bei nachfolgenden Bearbeitungsschritten zu schützen. Zur weiteren Herstellung der Halbleiterstruktur oder zur Herstellung einer weiteren auf dem Substrat auszubildenden Halbleiterstruktur wird mindestens ein Zwischenprozess ausgeführt. Die Schutzschicht wird von der zu schützenden Halbleiterstruktur entfernt, beispielsweise um diese weiter zu strukturieren.

Aus EP-A-0 316 550, US-A-4 654 269, JP 03 213870A, EP-A-0 312 154, US-B-6 177 338 und US-A-6 017 614 sind Verfahren mit Schutzschichten bekannt.

Das Substrat ist beispielsweise eine Halbleiterscheibe, d.h. ein sogenannter Wafer. Eingesetzt werden aber auch Keramiksubstrate oder Dünnfilmsubstrate.

Ein Prozess ist die Bearbeitung des Substrates bei gleichbleibenden Prozessbedingungen in einer Bearbeitungsanlage, z.B. Ausführen einer Oxidation, Abscheiden einer Schicht, Aufbringen einer Fotomaske, Belichten, Entwickeln, Ätzen, Ionenimplantation.

Beispielsweise ist es erforderlich, beim Herstellen von sogenannten BICMOS-Schaltkreisen (Bipolar Complementary Metall Oxide Semiconductor) Halbleiterstrukturen in der einen Basistechnologie zu schützen, wahrend die Halbleiterstrukturen der anderen Basistechnologie gefertigt werden. Dabei ist unter Umständen auch ein mehrfacher Wechsel zwischen den jeweils zu schützenden Gebieten und den jeweils zu bearbeitenden Gebieten erforderlich.

Es ist Aufgabe der Erfindung, ein verbessertes Verfahren zum Herstellen einer Halbleiterstruktur unter Verwendung einer Schutzschicht anzugeben.

Diese Aufgabe wird durch die im Patentanspruch 1 angegebenen Verfahrensschritte gelöst. Weiterbildungen sind in den Unteransprüchen angegeben.

Die Erfindung geht von der Überlegung aus, dass die bekannten Schutzschichten grundsätzlich einen ausreichenden Schutz gewährleisten, um beispielsweise Beschädigungen der zu schützenden Halbleiterstruktur zu vermeiden. Jedoch wird die Schutzschicht üblicherweise auf einer topologiehaltigen Oberfläche aufgebracht, d.h. auf einer unebenen Fläche, beispielsweise mit Höhenunterschieden von über 100 nm. Bei der Ausführung der Zwischenprozesse wird die Schutzschicht in ihrer chemischen und auch in ihren mechanischen Eigenschaften beeinflusst.

Beispielsweise kommt es aufgrund von Temperatur zu einem Schrumpfen der Schutzschicht und damit zum Entstehen von Zugkräften in lateraler Richtung. Diese Zugkräfte haben insbesondere an den Stellen, an denen Höhenunterschiede der Schutzschicht auftreten, das Entstehen von Scherkräften und gegebenenfalls auch von Kerbwirkungen zur Folge. Aufgrund der lateralen Kräfte kann es zur Bildung von Rissen und Spalten in der Schutzschicht kommen.

Beispielsweise gibt es auf einem Wafer mit einem Durchmesser von bspw. 6" oder 12" (Zoll) (150 mm oder 300 mm) nur drei oder vier solcher Risse. Diese Risse sind insbesondere deshalb sehr störend, weil sie die Wirkung der Schutzschicht herabsetzen, so dass nicht funktionsfähig Bauelemente hergestellt werden oder es zu langfristigen Zuverlässigkeitsproblemen kommt. In den Riss eindringende Ablagerungen diffundieren oft erst sehr langsam zu der Halbleiterstruktur und führen dort zu Spätausfällen, die erst im Gerät des Endkunden auftreten. Der Riss ist beispielsweise nur wenige Nanometer breit und nur wenige Nanometer tief. Die Länge des Risses liegt beispielsweise bei einigen Nanometern, bei einigen zehn Nanometern bzw. bei einigen hundert Nanometern.

Die Erfindung geht außerdem von der Überlegung aus, dass es nur schwer möglich ist die Anzahl der Risse herabzusetzen, da Maßnahmen zur Vermeidung von Rissbildung sehr aufwendig sind.

Deshalb wird beim erfindungsgemäßen Verfahren eine Schutzschicht aufgebracht, die eine Dicke hat, bei der während der Zwischenprozesse Risse auftreten. Das heißt mit anderen Worten, dass die Rissbildung beim erfindungsgemäßen Verfahren hingenommen wird. Jedoch wird beim erfindungsgemäßen Verfahren auf die in ihrer Schutzwirkung beeinträchtigte Schutzschicht eine Reparaturschicht aufgebracht, welche die Schutzwirkung der Schutzschicht wieder so erhöht, dass die reparierte Schutzschicht die zu schützende Halbleiterstruktur bei nachfolgenden Prozessen wieder wirksam schützt.

Beim erfindungsgemäßen Verfahren wird die Reparaturschicht vor dem Aufbringen weiterer Schichten und/oder vor dem Ausführen der nachfolgenden Prozesse z.B. mit einer Festzeitätzung oder einer Endpunktätzung wieder entfernt, um das Substrat weiter zu bearbeiten. Dabei verbleiben jedoch Reste der Reparaturschicht in den Rissen der Schutzschicht und bei tiefergehenden Rissen auch in der zu schützenden Halbleiterstruktur bzw. in einem zu schützenden Substrat. Diese Reste erhöhen gerade die Schutzwirkung der Schutzschicht. Außerdem ist ein Verbleiben von Resten der Reparaturschicht in den Rissen der Schutzschicht nur dann möglich, wenn die Schutzschicht beim Entfernen der Reparaturschicht nicht entfernt wird.

Durch den Einsatz des erfindungsgemäßen Verfahrens wird somit erreicht, dass auch bei einer einfachen Verfahrensführung, d.h. beim Aufbringen einer vergleichsweise dünnen Schutzschicht und beispielsweise beim Aufbringen einer Schutzschicht, die nur ein Material enthält, nach der Reparatur dennoch eine hohe Schutzwirkung und damit eine hohe Ausbeute erreicht werden. Insbesondere werden die besonders kritischen Spätausfälle vermieden. Das Aufbringen einer weiteren Schicht mit voller Schutzwirkung unterbleibt.

Bei einer Weiterbildung des erfindungsgemäßen Verfahrens ist die Dicke der Reparaturschicht wesentlich geringer als die Dicke der Schutzschicht. Beispielsweise ist die Dicke der Reparaturschicht kleiner als etwa ein Drittel der Dicke der Schutzschicht, kleiner als etwa ein Zehntel der Dicke der Schutzschicht oder kleiner als etwa ein Hundertstel der Dicke der Schutzschicht. Eine Reparaturschicht zur Reparatur einer 100 nm (Nanometer) dicken Schutzschicht hat beispielsweise eine Dicke von 20 nm.

Die Dicke der Reparaturschicht (50, 150) beträgt bei einer Ausgestaltung die Hälfte der größten Rissbreite, so dass auch der Riss mit der größten Rissbreite gerade noch sicher gefüllt wird. Sind alle Risse gefüllt, so wird die Abscheidung der Reparaturschicht beendet ohne die Dicke der Reparaturschicht noch weiter zu erhöhen. Das Aufbringen einer so dünnen Reparaturschicht ist einfach und schnell auszuführen. Außerdem lässt sich eine dünne Reparaturschicht leichter entfernen als eine dickere Reparaturschicht.

Bei einer nächsten Weiterbildung des erfindungsgemäßen Verfahrens besteht die Reparaturschicht aus dem gleichen Material wie das Material der Schutzschicht. Dadurch wird erreicht, dass Schutzschicht und die in den Rissen enthaltenen Ablagerungen der Reparaturschicht gleiche Ätzeigenschaften haben. Ein Freiätzen der Risse bei späteren Ätzvorgängen lässt sich so wirksam vermeiden. Bei einer Ausgestaltung wird die Reparaturschicht mit dem gleichen Verfahren wie die Schutzschicht aufgebracht. Auch diese Maßnahme führt beispielsweise zu gleichen Ätzeigenschaften von Schutzschicht und Reparaturschicht. So lässt sich als Schutzschicht TEOS (Tetra-Ethyl-Ortho-Silicate) einsetzen, das beispielsweise verdichtet bzw. verfestigt worden ist. Zur Reparatur der Schutzschicht wird dann auch TEOS eingesetzt, das ebenfalls anschließend verdichtet wird.

Bei einer alternativen Weiterbildung besteht die Reparaturschicht aus einem anderen Material als das Material der Schutzschicht. Durch diese Maßnahme entstehen Freiheitsgrade, die es erlauben, als Reparaturschicht Schichten aus Materialien einzusetzen, die auch zum Herstellen von Strukturen in den nicht geschützten Bereichen des Substrates dienen. Bei einer Ausgestaltung wird die Reparaturschicht mit einem anderen Verfahren als die Schutzschicht aufgebracht, wobei die Reparaturschicht wahlweise aus dem gleichen oder aus einem anderen Material als die Schutzschicht besteht. Auch durch diese Maßnahme entstehen Freiheitsgrade, die es erlauben, Prozesse zum Aufbringen bzw. Entfernen der Reparaturschicht später auch zum Herstellen der Strukturen in den nicht durch die Schutzschicht geschützten Bereichen zu nutzen.

Bei einer nächsten Weiterbildung des erfindungsgemäßen Verfahrens wird durch die Schutzschicht eine Feldeffekt-Struktur geschützt, d.h. eine Struktur, deren Arbeitsweise auf dem Feldeffekt beruht, z.B. eine MOS-Struktur (Metall-Oxid-Silizium). Diese Struktur enthält unter anderem eine Gateelektrode, eine Gateisolationsschicht, einen Abstandshalter und gegebenenfalls auch LDD-Anschlussgebiete (lightly doped drain) für Drain- und Sourcegebiete, die selbst höher dotiert sind, d.h. sogenannte HDD-Gebiete (highly doped drain). Das erfindungsgemäße Verfahren ist insbesondere zum Schutz des gesamten Gates, insbesondere zum Schutz der Gateisolationsschicht geeignet. Die Gateisolationsschicht ist nur wenige Nanometer dick, so dass sie sehr empfindlich ist, insbesondere auch gegen das Eindiffundieren von Verschmutzungen, die durch die nicht repariercen Risse in die Nähe der Gateisolationsschicht gelangen könnten.

Bei einer nächsten Weiterbildung des erfindungsgemäßen Verfahrens ist die weitere Halbleiterstruktur ein Bipolartransistor. Insbesondere bei der Herstellung von BICMOS-Strukturen werden Schutzschichten benötigt, die einen wirksamen Schutz bieten. Durch das Verwenden der Schutzschichten wird erreicht, dass Freiheitsgrade in der Verfahrensführung entstehen, die es ermöglichen, beispielsweise zunächst die vergrabenen Schichten für die Kollektoranschlüsse des Bipolartransistors herzustellen, danach die MOS-Strukturen vollständig oder doch teilweise zu fertigen und erst nach dem Aufbringen einer Schutzschicht auf die MOS-Struktur den Bipolartransistor weiter zu fertigen.

Bei einer nächsten Weiterbildung des erfindungsgemäßen Verfahrens wird zum Abscheiden der Reparaturschicht eine konforme Abscheidung benutzt, welche in der Lage ist, Spalten oder Risse vollständig zu füllen, d.h. ohne Hohlräume. Die konforme Abscheidung wird mit einem reaktionsbegrenzten Abscheideprozess erreicht, d.h. ein Abscheideprozess, bei dem im Gegensatz zu einem diffusionsbegrenzten Abscheideprozess die Abscheiderate durch die Reaktionsbedingungen, insbesondere durch die Temperatur, nicht jedoch durch einen Mangel an abzuscheidenden Teilchen begrenzt wird. Ein vollständig gefüllter Riss erhöht die Schutzwirkung der Schutzschicht wesentlich besser als ein Riss, der nur teilweise gefüllt ist und einen Hohlraum enthält, d.h. einen sogenannten void.

Bei einer anderen Weiterbildung des erfindungsgemäßen Verfahrens ist die Schutzschicht eine Siliziumdioxidschicht oder eine TEOS-Schicht. Als Material für die Reparaturschicht wird ebenfalls Siliziumdioxid oder TEOS eingesetzt. Die genannten Materialien lassen sich auf einfache Art aufbringen und mit Hilfe von Ätzprozessen wieder entfernen.

Bei einer nächsten Weiterbildung enthalt die zu schützende Halbleiterstruktur Abstandsstrukturen für die Implantation.

Diese Abstandsstrukturen werden auch als Spacer bezeichnet. Die Abstandsstrukturen sind beispielsweise aus Siliziumdioxid hergestellt oder aus TEOS. Alternativ lässt sich jedoch auch Nitrid als Material für die Abstandsstrukturen einsetzen.

Beim erfindungsgemäßen Verfahren wird nach der Reparatur der Schutzschicht und der Ausführung der Nachfolgeprozesse die Schutzschicht wieder entfernt. Durch diese Maßnahme wird erreicht, dass die zu schützende Halbleiterstruktur zu einem vergleichsweise späten Zeitpunkt im Gesamtprozess weiter bearbeitet werden kann, beispielsweise durch Bildung einer Silizidschicht. Zum Entfernen der Schutzschicht müssen auch die Reparaturschicht oder eine auf die Reparaturschicht aufgebrachte Schicht entfernt werden. Risse, welche die Schutzschicht durchdringen, bleiben auch nach dem Entfernen der Schutzschicht verschlossen, bspw. aufgrund des Einsatzes eines isotropen Ätzprozesses zum Entfernen der Schutzschicht.

Bei einer anderen Weiterbildung des erfindungsgemäßen Verfahren wird der Zwischenprozess bei einer Temperatur zwischen etwa 700°C bis etwa 900°C ausgeführt. Bei diesen Temperaturen kommt es oft zu einem besonders starken Schrumpfen der Schutzschicht durch thermisches Verdichten, beispielsweise bei Schutzschichten aus TEOS. Rissbildungen sind deshalb besonders zu befürchten.

Mindestens ein nachfolgender Prozess ist bei einer Weiterbildung derart, dass ohne Aufbringung einer Reparaturschicht die durch die Schutzschicht zu schützende Halbleiterstruktur beim Durchführen nachfolgender Prozesse aufgrund der herabgesetzten Schutzwirkung beschädigt und/oder in ihrer Funktion, insbesondere in ihrer Langzeitfunktion, beeinträchtigt werden würde. Das bedeutet mit anderen Worten zum einen, dass der nachfolgende Prozess bis an die Schutzschicht heranreicht. Zum anderen muss die Reparaturschicht allein keine ausreichende Schutzwirkung gegen den nachfolgenden Prozess erbringen und kann somit im Vergleich zur Schutzschicht sehr dünn sein. Die ausreichende Schutzwirkung ergibt sich aus dem Zusammenwirken von Schutzschicht und Reparaturschicht bzw. von Schutzschicht und von Resten der Reparaturschicht in den Rissen. Beispielsweise wäre ohne Reparatur ein isotropes Ätzverfahren zum Entfernen der Schutzschicht deshalb nicht einsetzbar, weil das Ätzen im Bereich der nicht reparierten Risse wesentlich schneller verläuft. Auch könnte beim Entfernen der nicht reparierten Schutzschicht eine unter der Schutzschicht liegende Struktur nicht mehr sinnvoll als Ätzstoppschicht in einem selektiven Ätzverfahren eingesetzt werden, weil das Ätzmittel die Ätzstoppschicht durch die Risse umgeht. Ein weiteres Beispiel für einen nachfolgenden Prozess, der bis an die Schutzschicht heranreicht, ist ein Ofenprozess bei dem Verschmutzungen bzw. Verunreinigungen zwar durch die dünne Reparaturschicht dringen jedoch von der Schutzschicht bzw. von dem in den Rissen enthaltenen Material der Reparaturschicht aufgehalten werden.

Im Folgenden werden Ausführungsbeispiele der Erfindung an Hand der Figuren 2A bis 2D erläutert. Darin zeigen:
- Figuren 1A bis 1D: Verfahrensschritte zum Reparieren einer Schutzschicht, die auf der zu schützenden Struktur verbleibt,
- Figuren 2A bis 2D: Verfahrensschritte zum Reparieren einer Schutzschicht, die nach dem Erbringen der Schutzwirkung wieder von der zu schützenden Struktur entfernt wird, und
- Figur 3: eine Transistorstruktur mit einem Abstandshalter aus Nitrid.

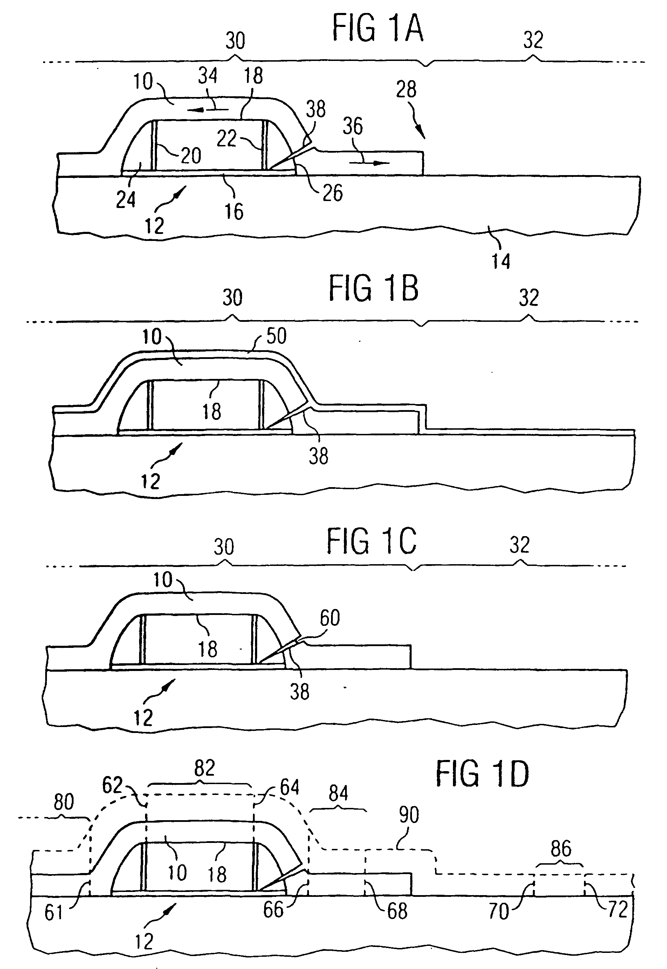

Die Figuren 1A bis 1C zeigen Verfahrensschritte zum Reparieren einer Schutzschicht 10, die auf eine zu schützende Transistorstruktur 12 aufgebracht worden ist. Die Figuren 1A bis 1C dienen dem besseren Verständnis der Erfindung. Die Transistorstruktur 12 befindet sich auf einem Silizium-Halbleiterwafer 14, der beispielsweise eine Dicke von 770 µm (Mikrometer) und einen Durchmesser von 300 mm (12 Zoll) hat. Jedoch sind die Verfahrensschritte unabhängig von der Größe des Wafers.

Die Transistorstruktur 12 enthält ein dünnes Gateoxid 16, das beispielsweise 7,5 nm (Nanometer) oder 15 nm dick ist. Das Gateoxid 16 wird durch eine Siliziumdioxidschicht gebildet, welche direkt auf den Wafer 14 aufgebracht worden ist. An Stelle der Siliziumdioxidschicht lässt sich auch ein anderes Dielektrikum verwenden, z.B. Siliziumnitrid.

Auf dem Gateoxid 16 wurde anschließend eine Gateelektrode 18 durch Abscheiden einer Polysiliziumschicht sowie Dotieren und Strukturieren dieser Schicht hergestellt. An den Seiten der Gateelektrode 18 wurde Seitenwandoxid 20, 22 abgeschieden, beispielsweise ebenfalls Siliziumdioxid. Das Seitenwandoxid 20 bzw. 22 trennt die Gateelektrode 18 von Abstandshaltern 24 bzw. 26, die aus TEOS bestehen, das in einem Verdichtungsprozess verdichtet worden ist.

Die Transistorstruktur 12 enthält außerdem ein p-dotiertes Kanalgebiet und n-dotierte Anschlussgebiete, die jedoch in Figur 1A nicht dargestellt sind. Die ebenfalls mit einer p-Dotierung zu versehenden Drain-Source-Gebiete werden später mit Hilfe der Abstandshalter 24, 26 implantiert.

Die Schutzschicht 10 besteht aus TEOS, hat bspw. eine Dicke von 100 nm und wurde nach ihrer Abscheidung mit Hilfe eines Fotolithografieverfahrens strukturiert, siehe beispielsweise Kante 28, die einen zu schützenden Bereich 30 von einem nicht zu schützenden Bereich 32 trennt.

Nach dem Strukturieren der Schutzschicht 10 wurden im nicht zu schutzenden Bereich 32 Verfahrensschritte zum Herstellen eines Bipolartransistors ausgeführt, die jedoch nicht näher erläutert werden. Bei den Verfahrensschritten zum Herstellen des Bipolartransistors war es jedoch erforderlich, den Wafer 14 und damit auch die Transistorstruktur 12 sowie die Schutzschicht 10 auf eine Temperatur von etwa bspw. 700°C zu erhitzen, d.h. auf die für Schichtabscheidungen typische Temperatur. Durch das Erhitzen wurden beispielsweise aber auch implantierte Gebiete des Bipolartransistors bei etwa 1000°C ausgeheilt. In Folge des Erhitzens schrumpfte die Schutzschicht 10, beispielsweise um 10 %. Durch das Schrumpfen entstanden Zugkräfte, die in Figur 1A durch Pfeile 34 und 36 dargestellt sind. Aufgrund der Zugkräfte 34 und 36 entstand im Bereich der Abstandshalter 24 und 26 eine Scherkraft, die im Bereich des Abstandshalters 26 zur Bildung eines Risses 38 führte, der sich durch die Schutzschicht 10 hindurch bis in den Abstandshalter 22 ausbildete.

Die in Figur 1A gezeigte Lage und Richtung des Risses 38 ist nur ein Beispiel. So gibt es Risse, die den Abstandshalter 22 an anderer Stelle berühren, die einen anderen Lagewinkel bezüglich der Oberfläche des Wafers 14 haben und die eine andere Risstiefe als der in Figur 1A dargestellte Riss 38 haben. So gibt es auch Risse, die bis in den Wafer 14 hineinreichen, bzw. welche die Schutzschicht 10 nicht vollständig durchstoßen. Auch die Länge der Risse ist unterschiedlich.

Figur 1B zeigt die in Figur 1A dargestellte Transistorstruktur 12 nach dem Aufbringen einer Reparaturschicht 50, die ebenfalls aus TEOS besteht. Die Reparaturschicht 50 ist wesentlich dünner als die Schutzschicht 10, beispielsweise hat die Reparaturschicht 50 nur eine Dicke von 20 nm. Die Reparaturschicht 50 wurde mit Reaktionsbedingungen aufgebracht, die eine konforme Abscheidung gewährleisten, so dass die Reparaturschicht 50 sowohl in dem zu schützenden Bereich 30 als auch in dem nicht zu schützenden Bereich 32 eine gleichmäßige Dicke von 20 nm hat. Die Reparaturschicht 50 verbleibt bei dem in Figur 1B gezeigten Ausführungsbeispiel großflächig auf der Schutzschicht 10 bzw. auf dem Bereich 32.

Figur 1C zeigt die in Figur 1B dargestellte Struktur nach einem Rückätzschritt, in welchem nur die Reparaturschicht 50 entfernt worden ist, die Schutzschicht 10 jedoch auf der Transistorstruktur 12 bzw. auf dem Wafer 14 verbleibt. Dabei wurde nicht überätzt, d.h. die Schutzschicht 10 behält ihre ursprüngliche Dicke. Im Bereich des Risses 38 verbleiben Reste 60, die den Riss 38 weiterhin im Wesentlich vollständig verschließen. Durch das Rückätzen wird der nicht zu schützende Bereich 30 wieder freigelegt.

Figur 1D zeigt mit Hilfe von gestrichelten Linien 61 bis 72 Bereiche 80 bis 86, in denen die Schutzschicht 10 und gegebenenfalls weitere Schichten 90 zum Einbringen von Metallisierungen entfernt werden.

Durch die Reparatur des Risses 38 wird vermieden, dass Verunreinigungen beim Aufbringen der Schichten 90 oder beim Ausführen anderer Prozesse in den Riss 38 eindringen.

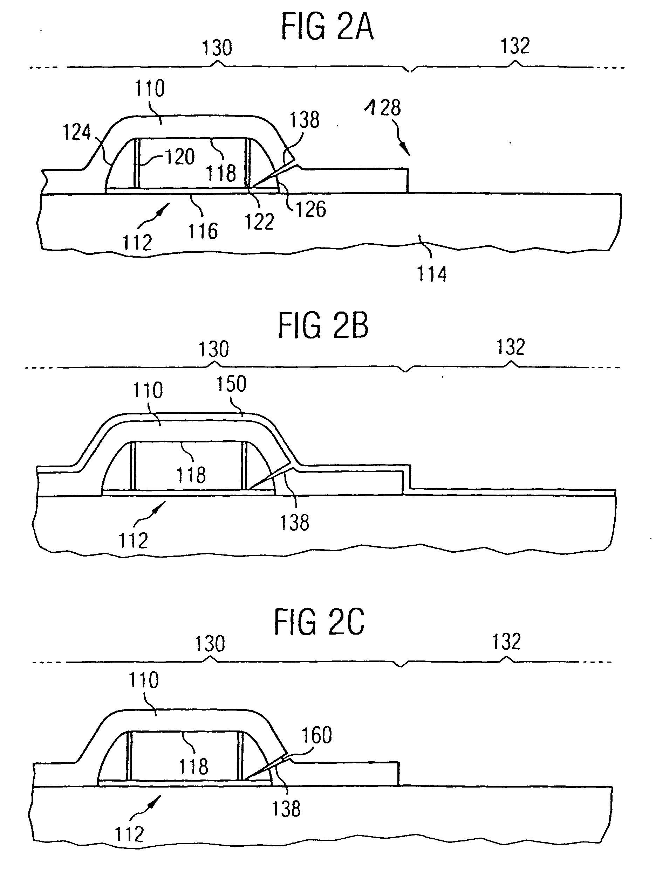

Die Figuren 2A bis 2D zeigen in einem zweiten Ausführungsbeispiel Verfahrensschritte zur Reparatur einer Schutzschicht 110, die nach dem Erbringen ihrer Schutzfunktion von einer zu schützenden Transistorstruktur 112 wieder entfernt wird.

Die Transistorstruktur 112 enthält ein dünnes Gateoxid 116, das beispielsweise 7,5 nm oder 15 nm dick ist. Das Gateoxid 116 wird durch eine Siliziumdioxidschicht gebildet, welche direkt auf einen Silizium-Halbleiterwafer 114 abgeschieden worden ist. Auf dem Gateoxid 116 wurde eine Gateelektrode 118 durch Abscheiden einer Polysiliziumschicht sowie Dotieren und Strukturieren dieser Schicht hergestellt. An den Seiten der Gateelektrode 118 wurde Seitenwandoxid 120, 122 abgeschieden, beispielsweise ebenfalls Siliziumdioxid. Das Seitenwandoxid 120 bzw. 122 trennt die Gateelektrode 118 von Abstandshaltern 124 bzw. 126, die aus TEOS bestehen, das in einem Verdichtungsprozess verdichtet worden ist.

Die Transistorstruktur 112 enthält außerdem ein n-dotiertes Kanalgebiet und p-dotierte Anschlussgebiete, die jedoch in Figur 2A nicht dargestellt sind. Die ebenfalls mit einer p-Dotierung zu versehenden Drain-Source-Gebiete werden später mit Hilfe der Abstandshalter 124, 126 implantiert.

Die Schutzschicht 110 besteht aus TEOS und wurde nach ihrer Abscheidung mit Hilfe eines Fotolithografieverfahrens strukturiert, siehe beispielsweise Kante 128, die einen zu schützenden Bereich 130 von einem nicht zu schützenden Bereich 132 trennt.

Nach dem Strukturieren der Schutzschicht 110 wurden im nicht zu schützenden Bereich 132 Verfahrensschritte zum Herstellen eines Bipolartransistors ausgeführt, die jedoch nicht näher erläutert werden. Bei den Verfahrensschritten zum Herstellen des Bipolartransistors war es jedoch erforderlich, den Wafer 114 und damit auch die Transistorstruktur 112 sowie die Schutzschicht 110 auf eine Temperatur von etwa 700°C zu erhitzen. In Folge des Erhitzens schrumpfte die Schutzschicht 110, beispielsweise um 10 %. Durch das Schrumpfen entstanden Zugkräfte, die in Figur 1A durch Pfeile 134 und 136 dargestellt sind. Aufgrund der Zugkräfte 134 und 136 entstand im Bereich der Abstandshalter 124 und 126 eine Scherkraft, die im Bereich des Abstandshalters 126 zur Bildung eines Risses 138 führte, der sich durch die Schutzschicht 110 hindurch bis in den Abstandshalter 126 ausbildete.

Die in Figur 2A gezeigte Lage und Richtung des Risses 138 ist nur ein Beispiel. So gibt es Risse, die den Abstandshalter 122 an anderer Stelle berühren, die einen anderen Lagewinkel bezüglich der Oberfläche des Wafers 114 haben und die eine andere Risstiefe als der in Figur 2A dargestellte Riss 138 haben. Auch die Länge der Risse ist unterschiedlich. So gibt es auch Risse, welche die Schutzschicht 110 nicht vollständig durchstoßen.

Figur 2B zeigt die in Figur 2A dargestellte Transistorstruktur 112 nach dem Aufbringen einer Reparaturschicht 150, die ebenfalls aus TEOS besteht. Die Reparaturschicht 150 ist wesentlich dünner als die bspw. 100 nm Dicke Schutzschicht 110, beispielsweise hat die Reparaturschicht 150 nur eine Dicke von 20 nm. Die Reparaturschicht 150 wurde mit Reaktionsbedingungen aufgebracht, die eine konforme Abscheidung gewährleisten, so dass die Reparaturschicht 150 sowohl in dem zu schützenden Bereich 130 als auch in dem nicht zu schützenden Bereich 132 eine gleichmäßige Dicke von 20 nm hat. Die Reparaturschicht 150 verbleibt bei dem in Figur 2B gezeigten Ausführungsbeispiel großflächig auf der Schutzschicht 110 bzw. auf dem Bereich 132.

Figur 2C zeigt die in Figur 2B dargestellte Struktur nach einem Rückätzschritt, in welchem nur die Reparaturschicht 150 entfernt worden ist, die Schutzschicht 110 jedoch auf der Transistorstruktur 112 bzw. auf dem Wafer 114 verbleibt. Dabei wurde nicht überätzt, d.h. die Schutzschicht 110 behält ihre ursprüngliche Dicke. Im Bereich des Risses 138 verbleiben Reste 160, die den Riss 138 weiterhin im Wesentlich vollständig verschließen. Durch das Rückätzen wird der nicht zu schützende Bereich 130 wieder freigelegt.

Nach dem Rückätzen der Reparaturschicht 150 werden im nicht zu schützenden Bereich 132 weitere Prozesse ausgeführt, beispielsweise Abscheidungen, Strukturierungen, Implantationen, Temperungen. Während dieser Prozesse schützt die Schutzschicht 110 die Transistorstruktur 112 weiterhin sehr wirkungsvoll, weil der Riss 138 repariert worden ist, siehe Reste 160 im Riss 138. Außerdem schrumpft Schutzschicht 110 während der nach der Reparatur ausgeführten Temperschritte nur noch unwesentlich, so das keine neuen Risse gebildet werden. Eine weiter Reparatur ist also nicht erforderlich und unterbleibt deshalb.

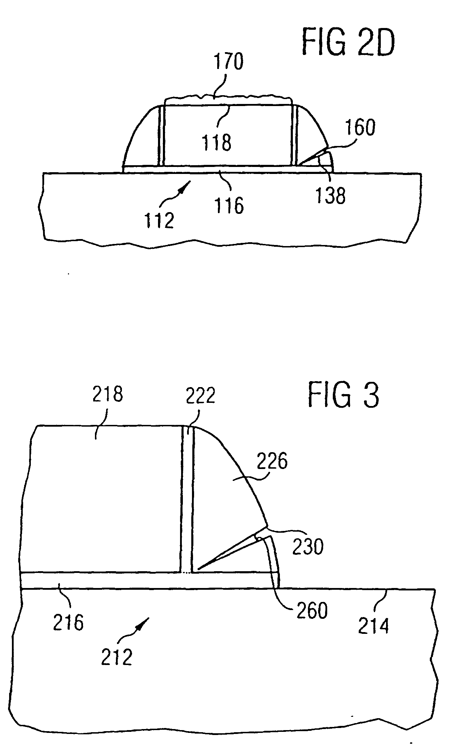

Figur 2D zeigt die in Figur 2C dargestellte Struktur nach einem isotropen Ätzschritt zum Entfernen der Schutzschicht 110. Die Transistorstruktur 112 wird durch den Ätzschritt wieder freigelegt, so dass sie in weiteren Prozessschritten bearbeitet werden kann, beispielsweise um Silizid zu bilden, z.B. Titansilizit. Nach dem Entfernen der Schutzschicht 110 ist der Riss 138 weiterhin durch Reste 160 der Reparaturschicht 150 verschlossen. Demzufolge können in den Riss 138 auch bei der Abscheidung der Silizitschicht 170 keine Verunreinigungen eindringen und so in die Nähe der extrem empfindlichen Gateisolationsschicht 116 gelangen.

Figur 3 zeigt eine Transistorstruktur 212, die auf einen Siliziumwafer 214 aufgebracht ist. Die Transistorstruktur 212 enthält ein Gateoxid 216, eine Gateelektrode 218, ein Seitenwandoxid 222 und einen Abstandshalter 226 aus Nitrid. Zum Schutz der Transistorstruktur 212 wurden die gleichen Verfahrensschritte ausgeführt, wie sie an Hand des Ausführungsbeispiels erläutert worden sind, d.h. insbesondere das Aufbringen einer Schutzschicht und einer Reparaturschicht. Die Schutzschicht und die Reparaturschicht bestehen beide bspw. aus Siliziumdioxid, das mit CVD-Verfahren (Chemical Vapor Deposition) aufgebracht wird. Nach dem Entfernen der Schutzschicht in einem selektiven Ätzprozess, z.B. mittels Flusssäure (HF), verbleiben in einem Riss 230 Reste 260, welche die Transistorstruktur 212 vor Verunreinigungen wirksam schützen. Die Reste 260 sind aus TEOS.

Bei anderen Ausführungsbeispielen werden Halbleiterstrukturen mit Hilfe der Schutzschicht geschützt, die sich von den in den Figuren dargestellten Halbleiterstrukturen unterscheiden, z.B. ein p-Kanal MOS-Transistor.

Es ergeben sich beim Einsatz der erläuterten Verfahren die folgenden Vorteile:
- Durch das Füllen von Rissen kann die ursprüngliche Funktion der Schutzschicht als Ätzstoppschicht wieder hergestellt werden.
- Die Schutzschicht kann durch eine isotrope Festzeitätzung oder durch eine Ätzung mit Endpunkterfassung entfernt werden, da durch die Reparatur wieder die ursprüngliche Mindestdicke der Schutzschicht hergestellt wird.
- Es ist nicht erforderlich, dass der Ätzprozess zum Entfernen der Abdeckschicht eine gute Selektivität zu der unter der Schutzschicht liegenden Struktur bzw. Schicht hat.
- Solange die Schichtdicke der Reparaturschicht mindestens die Hälfte der Rissbreite beträgt, werden Risse vollständig gefüllt.
- Es wird nur eine im Vergleich zur Schutzschicht dünne Reparaturschicht zusätzlich zur Schutzschicht abgeschieden. Die Schutzschicht hat nur ein Dicke, wie sie auch bei einer Schutzschicht erforderlich wäre bei der keine Maßnahmen gegen Rissbildung vorgesehen sind.
- Risse, die bis in das Substrat gehen oder bis in das Gateoxid reichen können nicht repariert werden. Jedoch wird durch das Verschließen dieser Risse eine Vergrößerung des Schadens bei nachfolgenden Prozessen vermieden.

## Patentansprüche

1. Verfahren zum Herstellen einer Halbleiterstruktur (12, 112),
bei dem auf eine Halbleiterstruktur (12, 112, 212) auf einem Substrat (14, 114) eine Schutzschicht (10, 110) aufgebracht wird,
bei dem mindestens ein Zwischenprozess ausgeführt wird, welcher zur Bildung von Rissen (38, 138) in der Schutzschicht (10, 110) führt,
bei dem auf die in ihrer Schutzwirkung beeinträchtigte Schutzschicht (10, 110) eine Reparaturschicht (50, 150) aufgebracht wird,
bei dem die Reparaturschicht (50, 150) vor dem Aufbringen weiterer Schichten (90) und/oder vor dem Ausführen nachfolgender Prozesse wieder entfernt wird,
und bei dem nach der Reparatur der Schutzschicht (10, 110) und nach dem besagten Aufbringen weiterer Schichten bzw. nach der Ausführung der nachfolgenden Prozesse die Schutzschicht (10, 110) entfernt wird.

2. Verfahren nach Anspruch 1, **dadurch gekennzeichnet, dass** die Dicke der Reparaturschicht (50, 150) wesentlich geringer ist als die Dicke der Schutzschicht (10, 110),
und/oder dass die Dicke der Reparaturschicht (50, 150) weniger als ein Drittel der Dicke der Schutzschicht (10, 110) beträgt,
und/oder dass die Dicke der Reparaturschicht (50, 150) die Hälfte der größten Rissbreite beträgt.

3. Verfahren nach Anspruch 1 oder 2, **dadurch gekennzeichnet, dass** die Reparaturschicht (50, 150) aus dem gleichen Material wie das Material der Schutzschicht (10, 110) besteht,
und/oder dass die Reparaturschicht (50, 150) mit dem gleichen Verfahren wie die Schutzschicht (10, 110) aufgebracht wird.

4. Verfahren nach Anspruch 1 oder 2, **dadurch gekennzeichnet, dass** die Reparaturschicht (50, 150) aus einem anderen Material als das Material der Schutzschicht (10, 110) besteht,
und/oder dass die Reparaturschicht (50, 150) mit einem anderen Verfahren als die Schutzschicht (10, 110) aufgebracht wird.

5. Verfahren nach einem der vorhergehenden Ansprüche, **dadurch gekennzeichnet, dass** die Reparaturschicht (50, 150) vor dem Aufbringen weiterer Schichten (90) und/oder vor dem Ausführen nachfolgender Prozesse mit einem isotropen Ätzverfahren und/oder mit einem nasschemischen Ätzverfahren und/oder mit einer Festzeitätzung oder einer Ätzung unter Erfassung des Endpunktes wieder entfernt wird,
wobei Reste der Reparaturschicht in den Rissen (138, 238) der Schutzschicht (110) verbleiben.

6. Verfahren nach einem der vorhergehenden Ansprüche, **dadurch gekennzeichnet, dass** die durch die Schutzschicht (10, 110) zu schützende Halbleiterstruktur (12, 112, 212) eine Feldeffekt-Struktur und/oder eine Transistorstruktur und/oder eine Gateisolationsschicht und/oder eine Abstandsstruktur für die Implantation von Source-Gebieten ist.

7. Verfahren nach einem der vorhergehenden Ansprüche, **dadurch gekennzeichnet, dass** auf dem Substrat (14, 114) eine Halbleiterstruktur (12, 112, 212) erzeugt wird,
dass die Schutzschicht (10, 110) auf die Halbleiterstruktur (12, 112, 212) aufgebracht wird,
und dass der Zwischenprozess zur weiteren Herstellung der Halbleiterstruktur (12, 112, 212) oder zur Herstellung einer weiteren auf dem Substrat (14, 114) auszubildenden Halbleiterstruktur (32, 132) ausgeführt wird.

8. Verfahren nach Anspruch 7, **dadurch gekennzeichnet, dass** die weitere Halbleiterstruktur (32, 132) ein Bipolartransistor ist.

9. Verfahren nach einem der vorhergehenden Ansprüche, **dadurch gekennzeichnet, dass** zum Abscheiden der Reparaturschicht (50, 150) ein konformer Abscheideprozess eingesetzt wird.

10. Verfahren nach einem der vorhergehenden Ansprüche, **dadurch gekennzeichnet, dass** die Schutzschicht (10, 110) eine Siliziumdioxidschicht ist,
und/oder dass die Schutzschicht (10, 110) eine TEOS-Schicht ist,
und/oder dass die Reparaturschicht (50, 150) eine Siliziumdioxidschicht ist,
und/oder dass die Reparaturschicht (50, 150) eine TEOS-Schicht ist.

11. Verfahren nach einem der vorhergehenden Ansprüche, **dadurch gekennzeichnet, dass** die zu schützende Halbleiterstruktur (12, 112) Abstandsstrukturen (26, 126, 226) für die Implantation enthält,
und dass die Abstandsstrukturen (26, 126, 226) Siliziumdioxid oder TEOS oder Nitrid enthalten.

12. Verfahren nach einem der vorhergehenden Ansprüche, **dadurch gekennzeichnet, dass** nach der Reparatur der Schutzschicht (10, 110) und nach der Ausführung der nachfolgenden Prozesse die Schutzschicht (10, 110) mit Hilfe eines isotropen Ätzverfahrens und/oder mit einem nasschemischen Ätzverfahren und/oder mit einer Festzeitätzung entfernt wird, und/oder dass entweder die Reparaturschicht (50, 150) und eine auf die Reparaturschicht (50, 150) aufgebrachte Schicht (90) entfernt wird oder dass eine nach dem Entfernen der Reparaturschicht (50, 150) aufgebrachte Schicht entfernt wird.

13. Verfahren nach einem der vorhergehenden Ansprüche, **dadurch gekennzeichnet, dass** der Zwischenprozess bei einer Temperatur von etwa 700°C bis 900°C ausgeführt wird.

14. Verfahren nach einem der vorhergehenden Ansprüche, **dadurch gekennzeichnet, dass** mindestens ein nachfolgender Prozess derart ist, dass ohne Aufbringen einer Reparaturschicht (50, 150) die durch die Schutzschicht (10, 110) zu schützende Halbleiterstruktur (12, 112) oder das zu schützende Substrat (14, 114) beim Durchführen des nachfolgenden Prozesses aufgrund der durch die Rissbildung herabgesetzten Schutzwirkung der Schutzschicht (10, 110) beschädigt und/oder in ihrer Funktion beeinträchtigt werden würde.

## Claims

1. Method for fabricating a semiconductor structure (12, 112),
in which a protective layer (10, 110) is applied to a semiconductor structure (12, 112, 212) on a substrate (14, 114),
in which at least one intermediate process is carried out, and this process leads to the formation of cracks (38, 138) in the protective layer (10, 110),
in which a repair layer (50, 150) is applied to the protective layer (10, 110), the protective action of which has been impaired,
in which the repair layer (50, 150) is removed again before further layers (90) are applied and/or before subsequent processes are carried out,
and in which the protective layer (10, 110) is removed after the protective layer (10, 110) has been repaired and after further layers have been applied or after the subsequent processes have been carried out.

2. Method according to Claim 1, **characterized in that** the thickness of the repair layer (50, 150) is significantly less than the thickness of the protective layer (10, 110),
and/or **in that** the thickness of the repair layer (50, 150) is less than one third of the thickness of the protective layer (10, 110),
and/or **in that** the thickness of the repair layer (50, 150) is half the maximum crack width.

3. Method according to Claim 1 or 2, **characterized in that** the repair layer (50, 150) consists of the same material as the material of the protective layer (10, 110),
and/or **in that** the repair layer (50, 150) is applied using the same process as the protective layer (10, 110).

4. Method according to Claim 1 or 2, **characterized in that** the repair layer (50, 150) consists of a different material from the material of the protective layer (10, 110),
and/or **in that** the repair layer (50, 150) is applied using a different process from the protective layer (10, 110).

5. Method according to one of the preceding claims, **characterized in that** the repair layer (50, 150) is removed again before further layers (90) are applied and/or before subsequent processes are carried out, by means of an isotropic etching process and/or by means of a wet-chemical etching process and/or by means of a fixed-time etch or an etch in which the end point is recorded,
residues of the repair layer remaining in the cracks (138, 238) in the protective layer (110).

6. Method according to one of the preceding claims, **characterized in that** the semiconductor structure (12, 112, 212) which is to be protected by the protective layer (10, 110) is a field-effect structure and/or a transistor structure and/or a gate insulation layer and/or a spacer structure for the implantation of source regions.

7. Method according to one of the preceding claims, **characterized in that** a semiconductor structure (12, 112, 212) is produced on the substrate (14, 114),
**in that** the protective layer (10, 110) is applied to the semiconductor structure (12, 112, 212),
and **in that** the intermediate process is carried out in order to further fabricate the semiconductor structure (12, 112, 212) or in order to fabricate a further semiconductor structure (32, 132) which is to be formed on the substrate (14, 114).

8. Method according to Claim 7, **characterized in that** the further semiconductor structure (32, 132) is a bipolar transistor.

9. Method according to one of the preceding claims, **characterized in that** a conformal deposition process is used to deposit the repair layer (50, 150).

10. Method according to one of the preceding claims, **characterized in that** the protective layer (10, 110) is a silicon dioxide layer,
and/or **in that** the protective layer (10, 110) is a TEOS layer,
and/or **in that** the repair layer (50, 150) is a silicon dioxide layer,
and/or **in that** the repair layer (50, 150) is a TEOS layer.

11. Method according to one of the preceding claims, **characterized in that** the semiconductor structure (12, 112) which is to be protected contains spacer structures (26, 126, 226) for the implantation,
and **in that** the spacer structures (26, 126, 226) contain silicon dioxide or TEOS or nitride.

12. Method according to one of the preceding claims, **characterized in that** the protective layer (10, 110) is removed after the protective layer (10, 110) has been repaired and after the subsequent processes have been carried out, with the aid of an isotropic etching process and/or with the aid of a wet-chemical etching process and/or with the aid of a fixed-time etch,
and/or **in that** either the repair layer (50, 150) and a layer (90) which has been applied to the repair layer (50, 150) are removed or a layer which has been applied after removal of the repair layer (50, 150) is removed.

13. Method according to one of the preceding claims, **characterized in that** the intermediate process is carried out at a temperature of approximately 700°C to 900°C.

14. Method according to one of the preceding claims, **characterized in that** at least one subsequent process is such that without the application of a repair layer (50, 150), the semiconductor structure (12, 112) which is to be protected by the protective layer (10, 110) or the substrate (14, 114) which is to be protected would be damaged when the subsequent process is carried out, on account of the reduced protective action of the protective layer (10, 110) on account of the crack formation, and/or its function would be impaired.

## Revendications

1. Procédé de fabrication d'une structure (12, 112) à semi-conducteur,
dans lequel on dépose sur une structure (12, 112, 212) à semi-conducteur, sur un substrat (14, 114), une couche (10, 110) de protection,
dans lequel on effectue au moins une opération intermédiaire qui provoque la formation de fissures (38, 138) dans la couche (10, 110) de protection,
dans lequel on dépose sur la couche (10, 110) de protection, à l'effet de protection de laquelle il a été porté atteinte, une couche (50, 150) de réparation,
dans lequel on élimine à nouveau la couche (50, 150) de réparation avant le dépôt d'autres couches (90) et/ou avant d'effectuer les opérations suivantes,
et dans lequel, après la réparation de la couche (10, 110) de protection et après ledit dépôt d'autres couches ou après avoir effectué les opérations suivantes, on élimine la couche (10, 110) de protection.

2. Procédé suivant la revendication 1, **caractérisé en ce que** l'épaisseur de la couche (50, 150) de réparation est sensiblement plus petite que l'épaisseur de la couche (10, 110) de protection,
et/ou **en ce que** l'épaisseur de la couche (50, 150) de réparation est inférieure au tiers de l'épaisseur de la couche (10, 110) de protection,
et/ou **en ce que** l'épaisseur de la couche (50, 150) de réparation représente la moitié de la plus grande largeur de fissure.

3. Procédé suivant la revendication 1 ou 2, **caractérisé en ce que** la couche (50, 150) de réparation est en le même matériau que le matériau de la couche (10, 110) de protection,
et/ou **en ce que** la couche (50, 150) de réparation est déposée par le même procédé que la couche (10, 110) de protection.

4. Procédé suivant la revendication 1 ou 2, **caractérisé en ce que** la couche (50, 150) de réparation est en un matériau autre que le matériau de la couche (10, 110) de protection,
et/ou **en ce que** la couche (50, 150) de réparation est déposée par un procédé autre que la couche (10, 110) de protection.

5. Procédé suivant l'une des revendications précédentes, **caractérisé en ce que** la couche (50, 150) de réparation est éliminée avant le dépôt d'autres couches (90) et/ou avant d'effectuer les opérations suivantes par un procédé d'attaque isotrope et/ou par un procédé d'attaque chimique en voie humide et/ou par une attaque pendant une durée fixe ou par une attaque avec détection du point final,
des restes de la couche de réparation restant dans les fissures (138, 238) de la couche (110) de protection.

6. Procédé suivant l'une des revendications précédentes, **caractérisé en ce que** la structure (12, 112, 212) à semi-conducteur à protéger par la couche (10, 110) de protection est une structure à effet de champ et/ou une structure à transistor et/ou une couche d'isolation de grille et/ou une structure de mise à distance pour l'implantation de zones de source.

7. Procédé suivant l'une des revendications précédentes, **caractérisé en ce qu'**on produit sur le substrat (14, 114) une structure (12, 112, 212) à semi-conducteur,
**en ce qu'**on dépose la couche (10, 110) de protection sur la structure (12, 112, 212) à semi-conducteur,
et **en ce que** l'on effectue l'opération intermédiaire pour produire encore la structure (12, 112, 212) à semi-conducteur ou pour produire une autre structure (32, 132) à semi-conducteur à constituer sur le substrat (14, 114).

8. Procédé suivant la revendication 7, **caractérisé en ce que** l'autre structure (32, 132) à semi-conducteur est un transistor bipolaire.

9. Procédé suivant l'une des revendications précédentes, **caractérisé en ce que**, pour le dépôt de la couche (50, 150) de réparation, on utilise une opération de dépôt conforme.

10. Procédé suivant l'une des revendications précédentes, **caractérisé en ce que** la couche (10, 110) de protection est une couche de dioxyde de silicium,
et/ou la couche (10, 110) de protection est une couche en TEOS,
et/ou la couche (50, 150) de réparation est une couche de dioxyde de silicium,
et/ou la couche (50, 150) de réparation est une couche en TEOS.

11. Procédé suivant l'une des revendications précédentes, **caractérisé en ce que** la structure (12, 112) à semi-conducteur à protéger comporte des structures (26, 126, 226) de mise à distance pour l'implantation,
et **en ce que** les structures (26, 126, 226) de mise à distance contiennent du dioxyde de silicium ou du TEOS ou du nitrure.

12. Procédé suivant l'une des revendications précédentes, **caractérisé en ce qu'**après la réparation de la couche (10, 110) de protection et après avoir effectué les opérations suivantes, on élimine la couche (10, 110) de protection à l'aide d'un procédé d'attaque isotrope et/ou d'un procédé d'attaque chimique en voie humide et/ou d'une attaque de durée fixe, et/ou on élimine soit la couche (50, 150) de réparation et une couche (90) déposée sur la couche (50, 150) de réparation, soit une couche déposée après l'élimination de la couche (50, 150) de réparation.

13. Procédé suivant l'une des revendications précédentes, **caractérisé en ce qu'**on effectue l'opération intermédiaire à une température de 700°C environ à 900°C.

14. Procédé suivant l'une des revendications précédentes, **caractérisé en ce qu'**au moins une opération suivante est telle que sans dépôt d'une couche (50, 150) de réparation, la structure (12, 112) à semi-conducteur à protéger par la couche (10, 110) de protection ou le substrat (14, 114) à protéger seraient endommagés et/ou il serait porté atteinte à leur fonction lorsque l'on effectue l'opération suivante en raison de l'effet de protection, diminuant la formation de fissures, de la couche (10, 110) de protection.
